# EUROPEAN PATENT APPLICATION

(11) **EP 4 842 154 A1**
(43) Date of publication of application: **18.11.2026**
(21) Application number: 26179018.2
(22) Date of filing: 15.05.2026
(51) Int. Cl.: H05K 7/20

(54) **RETENTION SYSTEMS AND METHODS FOR COOLANT DISTRIBUTION UNITS**

(30) Priority: 16.05.2025 US 202563807229 P
(71) Applicant: Hoffman Enclosures Inc., Anoka, MN 55303 (US)
(72) Inventor: Raisanen, Richard, Coon Rapids (US); Speight, Jacob, Anoka (US); Walther, Jack, Anoka (US)
(74) Representative: Barker Brettell LLP

(57) **Abstract**

A retention system (100) for retaining coolant distribution units (CDUs) (112) within a rack (116) includes a mounting bracket (104) secured to the rack, a first rod (108) slidably arranged through the mounting bracket and moveable between a first unlocked position and a first locked position, a ramp (144) arranged on the first rod, and a locking tab (148) arranged on the first rod. The ramp engages a first CDU to move the first rod into the first unlocked position when the first CDU is inserted and disengages to move the first rod into the first locked position when the first CDU is removed. The locking tab engages a second CDU when the first rod is in the first locked position. The first rod moves between positions in response to removal and reinsertion of the first CDU to engage and disengage the locking tab, locking and unlocking second CDU movement.

## Description

### CROSS-REFERENCE TO RELATED APPLICATIONS

This application claims priority to U.S. Provisional Patent Application No. 63/807,229, filed on May 16, 2025, the entirety of which is incorporated herein by reference.

### BACKGROUND

In data centers (or other environments) with a large number of electronic components (e.g., processors, etc.) a coolant distribution unit (CDU) may be used to efficiently cool the electronic components. In some examples, the CDU may be installed within a rack assembly via one or more slides (e.g., to permit insertion and removal of the CDU for maintenance, etc.). However, in some examples, when more than a single CDU is within a single rack, sliding out more than one CDU at one time may cause the rack to become unstable, which may be undesirable to a user.

### SUMMARY

According to one aspect of the present disclosure, a retention system for retaining coolant distribution units (CDUs) within a rack can include a mounting bracket secured to the rack. A first rod can be slidably arranged through the mounting bracket. The first rod can be moveable between a first unlocked position and a first locked position. A ramp can be arranged on the first rod. The ramp can be configured to engage a first CDU to move the first rod into the first unlocked position when the first CDU is inserted into the rack, and to disengage from the first CDU to move the first rod into the first locked position when the first CDU is removed from the rack. A locking tab can be arranged on the first rod. The locking tab can engage a second CDU when the first rod is in the first locked position. The first rod can be configured to move from the first unlocked position to the first locked position in response to removal of the first CDU to engage the locking tab with the second CDU and lock movement of the second CDU within the rack. The first rod can be further configured to move from the first locked position to the first unlocked position in response to reinsertion of the first CDU to disengage the locking tab from the second CDU and unlock movement of the second CDU within the rack.

In some examples, the retention system may further include a biasing element arranged around the first rod, between the ramp and the mounting bracket. The biasing element may bias the first rod to the first locked position.

In some examples, the retention system may permit removal of a single CDU from the rack at a time.

In some examples, the retention system may further include a locking flange secured to the first CDU. The locking flange may include an angled portion to interact with the ramp and move the first rod between the first unlocked position and the first locked position.

In some examples, the angled portion of the locking flange may contact a corresponding angled portion of the ramp to move the first rod from the first unlocked position to the first locked position.

In some examples, the locking flange may define a gap between the locking flange and the first CDU. The locking tab may be arranged within the gap when the first rod is in the first locked position.

In some examples, the retention system may further include a second rod arranged through the mounting bracket. The second rod may include a second ramp at a location corresponding to the second CDU and a second locking tab at a location corresponding to the first CDU.

In some examples, removal of the second CDU from the rack may move the second rod into a second locked position to engage the second locking tab with a second locking flange of the first CDU.

In some examples, the first rod and the second rod may each be independently moveable such that removal of the first CDU moves the first rod and removal of the second CDU moves the second rod.

According to another aspect of the present disclosure, a retention system for retaining coolant distribution units (CDUs) within a rack can include a mounting bracket secured to the rack. A first rod can be slidably arranged through the mounting bracket. The first rod can be moveable between a first unlocked position and a first locked position. The first rod can include a first ramp configured to engage a first CDU and a first locking tab configured to engage a second CDU. A second rod can be slidably arranged through the mounting bracket. The second rod can be moveable between a second unlocked position and a second locked position. The second rod can include a second ramp configured to engage the second CDU and a second locking tab configured to engage the first CDU. The first rod can be configured to move from the first unlocked position to the first locked position in response to removal of the first CDU to engage the first locking tab with the second CDU and lock movement of the second CDU within the rack. The second rod can be configured to move from the second unlocked position to the second locked position in response to removal of the second CDU to engage the second locking tab with the first CDU and lock movement of the first CDU within the rack.

In some examples, the retention system may further include a first biasing element arranged around the first rod and a second biasing element arranged around the second rod.

In some examples, the first biasing element may automatically move the first rod into the first locked position when the first CDU is removed from the rack. The second biasing element may automatically move the second rod into the second locked position when the second CDU is removed from the rack.

In some examples, the retention system may further include a first locking flange secured to the first CDU and a second locking flange secured to the second CDU. The first locking flange may include a first angled portion to interact with the first ramp. The second locking flange may include a second angled portion to interact with the second ramp.

In some examples, the first locking flange may define a first gap between the first locking flange and the first CDU. The second locking tab may be arranged within the first gap when the second rod is in the second locked position.

In some examples, the first rod and the second rod may each be independently moveable such that removal of the first CDU moves the first rod into the first locked position and removal of the second CDU moves the second rod into the second locked position.

According to yet another aspect of the present disclosure, a method of securing coolant distribution units (CDUs) within a rack can include removing a first CDU from the rack. The method can include disengaging the first CDU from a ramp arranged on a rod that is slidably arranged through a mounting bracket secured to the rack. The method can include automatically moving the rod from an unlocked position to a locked position via a biasing element in response to removal of the first CDU. The method can include engaging a locking tab arranged on the rod with a corresponding locking flange of a second CDU within the rack as the rod moves into the locked position. The method can include preventing removal of the second CDU from the rack while the locking tab is engaged with the locking flange.

In some examples, the method may further include reinserting the first CDU into the rack, automatically moving the rod into an unlocked position in response to reinsertion of the first CDU, disengaging the locking tab from the locking flange of the second CDU, and permitting removal of the first CDU or the second CDU from the rack when the locking tab is disengaged from the locking flange.

In some examples, automatically moving the rod into the unlocked position may include compressing the biasing element via contact between the first CDU and the ramp.

In some examples, automatically moving the rod into the locked position may include decompressing the biasing element to move the rod along a longitudinal axis of the rod until the locking tab engages the locking flange of the second CDU.

In some examples, the method may further include manually lifting the rod to disengage the locking tab from the locking flange to permit removal of multiple CDUs from the rack.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the system or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a rear view of a rack including one or more coolant distribution units (CDUs) retained via a retention system according to aspects of the present disclosure.
FIG. 2 is an axonometric view of an example of a first retention assembly of the retention system of FIG. 1.
FIG. 3 is an axonometric view of an example of a second retention assembly of the retention system of FIG. 1.
FIG. 4 is an axonometric view of an example of a third retention assembly of the retention system of FIG. 1.
FIG. 5 is an axonometric view of an example of a rod connection mechanism of the retention system of FIG. 1.
FIG. 6A is an axonometric view of the retention system of FIG. 1 in an unlocked configuration.
FIG. 6B is an axonometric view of the retention system of FIG. 1 in a locked configuration.
FIG. 7 is an axonometric view of the retention system of FIG. 1 in an unlocked position, with all of the CDUs installed within the rack.
FIG. 8 is an axonometric view of the retention system of FIG. 1 in a locked position, with none of the CDUs installed within the rack.
FIG. 9 is an axonometric view of the retention system of FIG. 1 in a locked position, with one of the CDUs removed from the rack.
FIG. 10 is an axonometric view of another example of a locking flange for use with the retention system of FIG. 1.
FIG. 11 is an axonometric view of another example of a retention assembly for use with the retention system of FIG. 1.
FIG. 12 is an axonometric view of a base and a retainer of the retention assembly of FIG. 11.
FIG. 13 is an axonometric view of the base of the retention assembly of FIG. 11.
FIG. 14 is an axonometric view of the retainer of the mounting bracket of FIG. 11.
FIG. 15 is a cross-sectional view of the retention assembly of FIG. 11.

### DETAILED DESCRIPTION

The following discussion is presented to enable a person skilled in the art to make and use embodiments of the invention. Given the benefit of this disclosure, various modifications to the illustrated embodiments will be readily apparent to those skilled in the art, and the principles herein can be applied to other embodiments and applications without departing from embodiments of the invention. Thus, embodiments of the invention are not intended to be limited to embodiments shown, but are to be accorded the widest scope consistent with the principles and features disclosed herein.

The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The present disclosure provides a retention system for retaining coolant distribution units (CDUs) within a rack. The retention system includes multiple mounting brackets secured to the rack and multiple rods arranged through the mounting brackets. In some examples, the number of rods and mounting brackets may correspond to the number of CDUs in the rack. In some examples, the system is configured to automatically lock in response to removal of one or more CDUs from the rack and automatically unlock in response to insertion of one or more CDUs into the rack.

In use, the retention system permits removal of a single CDU within the rack while automatically locking to prevent removal of other CDUs in the rack, mitigating the risk of creating a tipping hazard. In some examples, the system includes retention assemblies corresponding to each CDU, with each assembly having a bracket, biasing element, ramp, and locking tabs. During insertion of the CDU into the rack, a locking flange on the CDU (e.g., a locking flange on each CDU within the rack) interacts with the ramp to move the system (e.g., via vertical movement of one or more of the rods) between locked and unlocked positions.

In some examples, the rods include ramps and locking tabs positioned at different vertical locations, permitting selective locking of individual CDUs. Thus, when a CDU is removed from the rack, the corresponding rod moves to engage locking tabs with locking flanges of other CDUs within the rack, preventing their removal. Correspondingly, reinsertion of the CDU drive the locking flange into engagement with the locking tabs, which disengages the locking tabs, permitting removal of other (or the same) CDUs.

In some examples, the retention system may be manually overridden to permit multiple (e.g., more than one) CDU to be removed at a time (e.g., for initial installation, maintenance, replacement, etc.). For example, a user may manually lift the rods in order to disengage the locking tabs from the locking flanges, which permits the user to remove multiple CDUs from the rack, without removing the retention system.

As should be appreciated, the automated retention system ensures that only one CDU can be removed from the rack at a time, enhancing safety and stability of the rack. The retention system provides an efficient and reliable method for managing CDU removal and insertion.

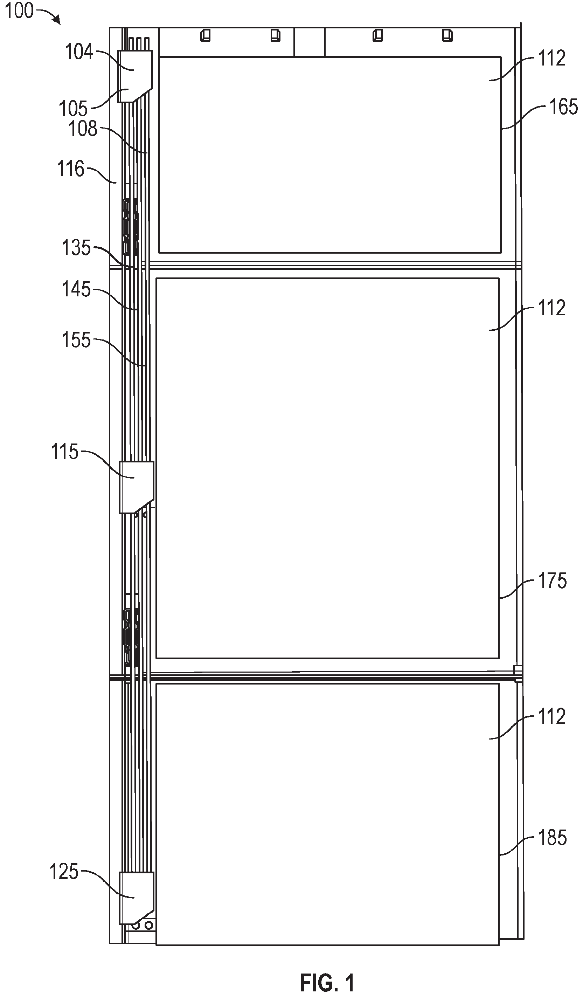

FIG. 1 shows an example of a retention system 100 for use in retaining one or more coolant distribution units (CDUs) 112 within a rack 116 (e.g., a cooling rack, server rack, etc.) In some examples, the retention system 100 may be configured to automatically lock (e.g., move into a locked position) in response to removal of one (or more) CDUs 112 from within the rack 116. Correspondingly, the retention system 100 may be configured to automatically unlock (e.g., move into an unlocked position) in response to insertion of all of (or substantially all of) the CDUs 112 into the rack 116. In some examples, the retention system 100 may further be configured to permit an operator to remove one (e.g., a single) CDU 112 from within the rack 116, but once the CDU is removed, the retention system 100 may automatically lock in order to prevent the removal of the other CDUs 112 within the rack 116, which may mitigate the risk of a user removing too many CDUs from the rack and creating a tipping hazard for the rack. Correspondingly, when the user reinserts the CDU into the rack 116, the retention system 100 may automatically unlock to permit a user to remove another CDU from the rack. Put differently, the retention system 100 may permit a user to only remove a single CDU 112 from within the rack 116 at a time, which may mitigate the risk of tipping over the rack.

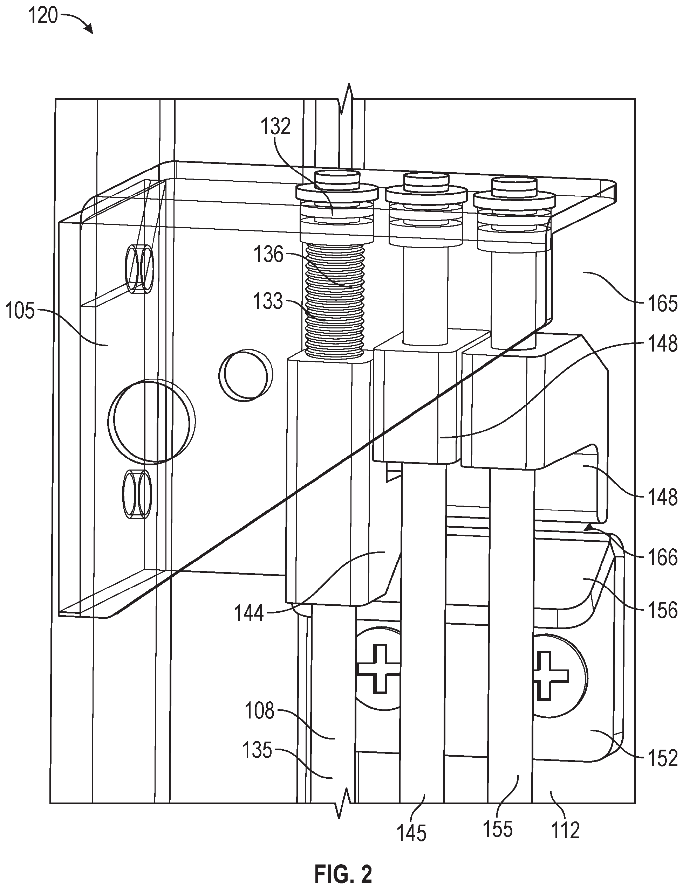

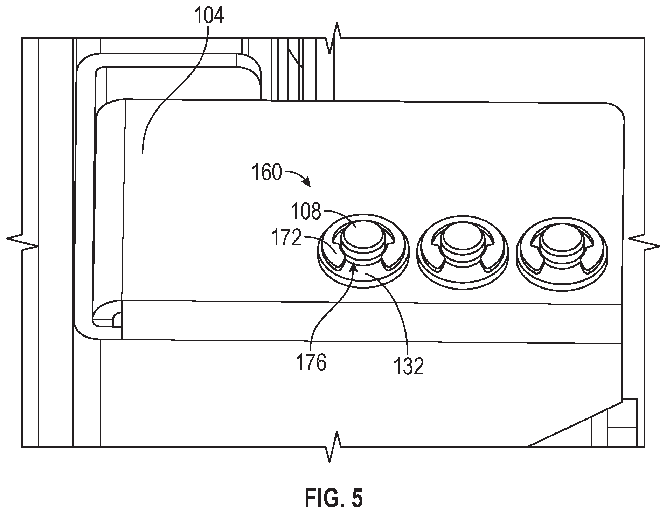

In some examples, the retention system 100 may be installed at a rear (e.g., a back, opposite of a rack door, etc.) of the rack 116. For example, one or more mounting brackets 104 may be secured (e.g., via fasteners, etc.) to the rack 116, with one or more rods 108 arranged through the mounting brackets 104 (e.g., arranged through a bushing 132 (see, e.g., FIG. 2) to reduce friction between the rod and the mounting bracket). In some examples, as shown in FIG. 5, the rods 108 may be arranged through the mounting brackets 104 (e.g., extending through the mounting brackets), with the rods further retained via retaining clips 172. In some examples, the retaining clips 172 may be arranged within a groove 176 defined by the rod 108, so that the retaining clip 172 is secured to the rod 108 and prevents the rod from sliding through an opening 160 in the mounting bracket 104. In some examples, the rods 108 may be installed by inserting them into the opening 160.

In some examples, the number of mounting brackets 104 and rods 108 may correspond to the number of CDUs 112 housed within the rack. For example, in the illustrated example, three mounting brackets 104 (e.g., a first mounting bracket 105, second mounting bracket 115, and third mounting bracket 125) and three rods 108 (e.g., a first rod 135, second rod 145, and third rod 155) may be used to correspond to the three CDUs 112 (e.g., a first CDU 165, second CDU 175, and third CDU 185) within the rack 116. However, as should be appreciated, other numbers of CDUs, mounting brackets, and rods may be used as desired by a user (e.g., depending on the given configuration of CDUs, etc.).

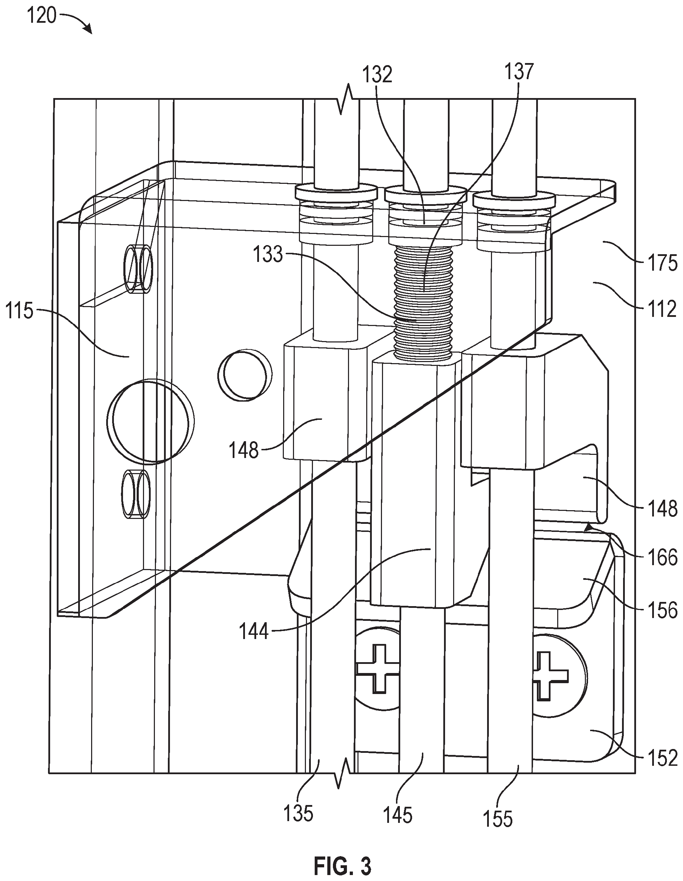

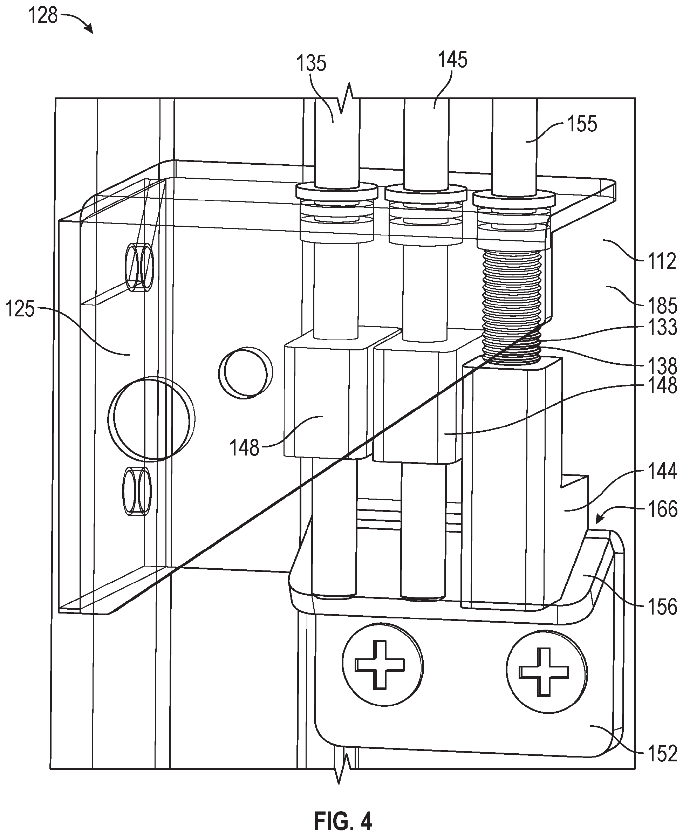

FIGS. 2-4 show an example of a first retention assembly 120, a second retention assembly 124, and a third retention assembly 128 of the retention system 100 (e.g., corresponding to the first, second, and third CDUs). In some examples, with respect to the first retention assembly, the first retention assembly 120 may correspond to a first vertical position (e.g., height) along the rack 116, which may further correspond to the location of a CDU (e.g., a first CDU 165) within the rack 116. In some examples, the first retention assembly 120 may be configured to interact with the first CDU 165 in order to adjust a position (e.g., a vertical position) of the first rod 135 (e.g., in response to contact with a portion of the first CDU). Put differently, the first retention assembly 120 may interact with the first CDU 165 in order to move the first rod 135 vertically between a first position (e.g., a locked position) and a second position (e.g., unlocked position), which may permit or restrict removal of the second and third CDUs.

In some examples, the first retention assembly 120 may include the first mounting bracket 105, a biasing element 133 (e.g., a first spring 136, etc.), one or more ramps 144, and one or more locking tabs 148 (e.g., positioned on the second and third rods 145, 155). Correspondingly, in order to actuate the first rod 135 (e.g., to move the retention system 100 between locked and unlocked positions), the first CDU 165 may include a locking flange 152. In some examples, the locking flange 152 may be secured to a rear (e.g., back) of the first CDU 165 via one or more fasteners arranged through the locking flange 152 and into the CDU. In some examples, the locking flange 152 may be secured to the CDU to define a gap 166 between the locking flange 152 and the CDU (e.g., in order to receive and retain the locking tabs 148). In some examples, the locking flange 152 may include an angled portion 156, which may be configured to interact with (e.g., contact) the ramp 144 (e.g., with a correspondingly angled portion) in order to move the first rod 135 between the first and second positions (e.g., locked and unlocked positions).

In some examples, the biasing element 133 may include alternative biasing mechanisms in addition to or instead of the spring 136. For example, the biasing element 133 may include a gas spring, an elastomeric element (e.g., rubber, silicone, etc.), a torsion spring, a leaf spring, or a magnetic biasing element (e.g., utilizing magnetic repulsion or attraction to provide a biasing force). In some examples, the spring characteristics (e.g., spring constants, compression ranges, etc.) of the biasing element 133 may be selected based on the weight of the CDUs 112 or a desired actuation force for moving the rods 108 between the locked and unlocked positions. In some examples, the biasing element 133 may be configured to provide a consistent biasing force throughout the range of motion of the rod 108, or may be configured to provide a variable biasing force (e.g., increasing force as the rod moves further from the locked position)

In the illustrated example, the first retention assembly 120 may include a portion of the first rod 135, the second rod 145, and the third rod 155 (e.g., a horizontal section of the rods, perpendicular to a length direction of the rods), which are each retained within the first mounting bracket 105 and correspond to the number of CDUs in the rack 116 (e.g., three, four, etc.). In one particular example, at the first retention assembly 120, the first rod 135 may include a ramp 144, while the second and third rods 145, 155 may each include a locking tab 148.

In general, along the length of each rod, the rods may each include a single ramp 144 and a pair (e.g., two) locking tabs 148. In some examples, the placement of the ramp 144 along the rod (e.g., vertically along the length of the rod) varies among the rods 108 within each retention assembly 120, 124, 128. Put differently, none of the rods 108 have the ramps 144 at the same vertical location. For example, in the first retention assembly 120 (e.g., a first vertical location), the first rod 135 includes a ramp, while the second rod 145 and the third rod 155 each include a locking tab 148. Thus, when a user removes a CDU (e.g., the first CDU 165), the movement of the CDU may result in movement of the first rod 135 in a first direction (e.g., downward relative to gravity, due to lack of contact between the locking flange 152 and the ramp 144 and a biasing force applied by the biasing element 133), which may engage the locking tabs 148 on the first rod 135 (e.g., aligned with the second and third CDUs) with the locking flange 152 and retain the second and third CDUs.

Correspondingly, when a user reinserts the CDU (e.g., the first CDU 165), the movement of the CDU may result in movement of the first rod 135 in a second direction (e.g., upward relative to gravity, due to contact between the locking flange 152 and the ramp 144), which may compress the biasing element 133 and disengage the locking tabs 148 on the first rod 135 (e.g., aligned with the second and third CDUs) from the locking flange 152 to release the second and third CDUs.

While the above description generally discussed the first retention assembly 120, it will be recognized that the second and third retention assemblies 124, 128 share a number of components in common with and operates in a similar fashion to the examples illustrated and described previously (e.g., the first retention assembly 120). For the sake of brevity, these common features will not be again described in detail. Rather, previous discussion of commonly named or numbered features, unless otherwise indicated, also applies to example configurations of the second and third retention assemblies 124, 128.

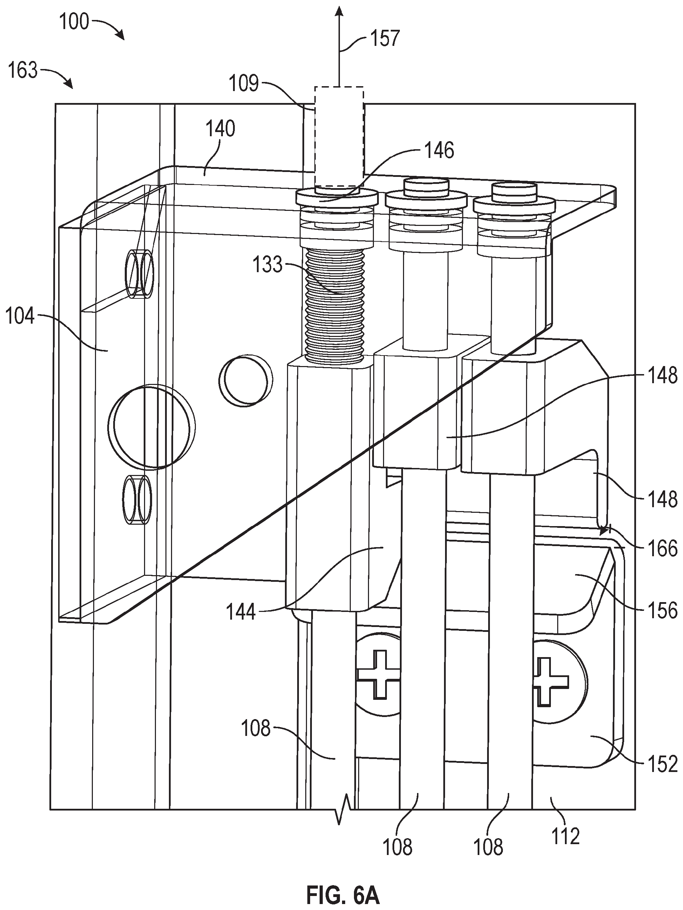

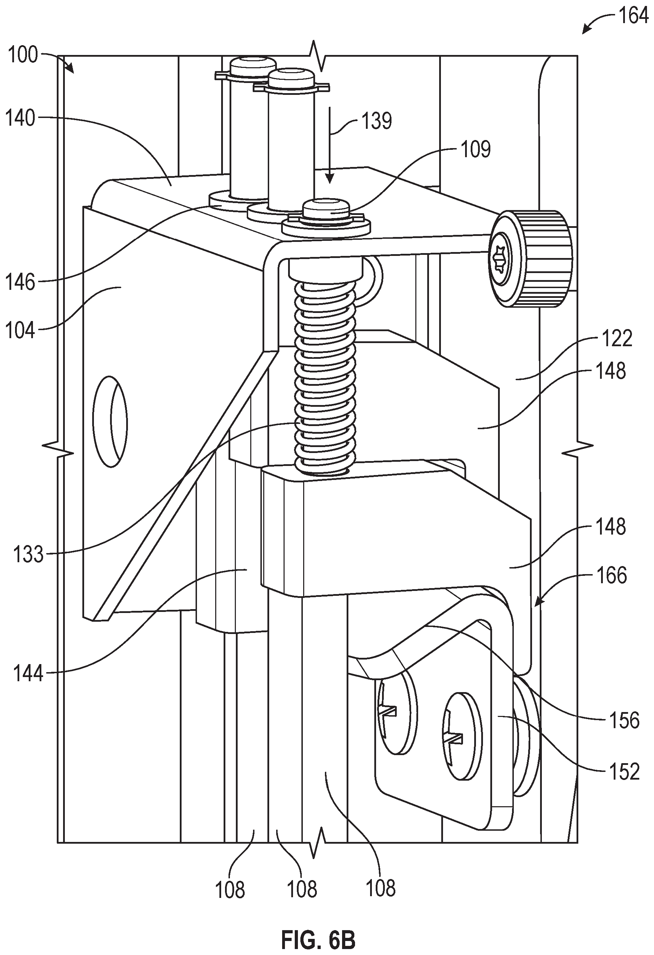

FIGS. 6A and 6B show an example of a portion of the retention system 100 (one of the retention assemblies) in an unlocked configuration 163 and a locked configuration 164, respectively. In some examples, as mentioned previously, when a CDU 112 is inserted into the rack 116, the locking flange 152 (e.g., the angled portion 156) contacts the ramp 144 on the corresponding rod 108. Engagement between the locking flange 152 and the ramp 144 may generate a force in the rod 108 (e.g., in the direction shown by arrow 157), which may compress the biasing element 133 and force a first end 109 of the rod 108 past a first surface 140 of the mounting bracket 104 (e.g., so the first end 109 of the rod 108 extends past the mounting bracket 104).

Further, as the rod 108 moves in the direction shown by arrow 157, the locking tabs 148 arranged along a length of the rod 108 may be moved in the direction shown by arrow 157, which may move the locking tabs 148 out of engagement with the locking flanges 152 (e.g., move the locking tabs 148 out of the gap formed by the locking flange and the CDU). In some examples, when all CDUs 112 are inserted into the rack 116 all of the rods 108 may be elevated, which may disengage the locking tabs 148 from the locking flanges 152 and permit a user to remove any one of the CDUs 112 from the rack 116 (e.g., slide the CDU out of the rack).

However, in some examples, when a user slides one of the CDUs 112 out from the rack 116, the ramp 144 may lose contact with the locking flange 152 (e.g., the angled portion 156), which may decompress the biasing element 133. As a result, the biasing element 133 may automatically drive the rod 108 downward (e.g., in the direction shown by arrow 139) until the first end 109 of the rod 108 contacts a retention flange 146 of the bushing 132 coupled to the mounting bracket 104. In some examples, once the first end 109 of the rod 108 contacts the retention flange 146 of the bushing 132, the locking tabs 148 on the rod 108 may slide within the gaps 166 formed by the locking flanges 152. Thus, due to the engagement between the locking tabs 148 and the locking flanges 152, movement of the remaining CDUs 112 may be prevented (e.g., until the removed CDU is reinserted). As a result of the above configuration, only a single CDU 112 may be removed from the rack 116 at any given time, which may mitigate the risk of tipping, etc. of the rack 116.

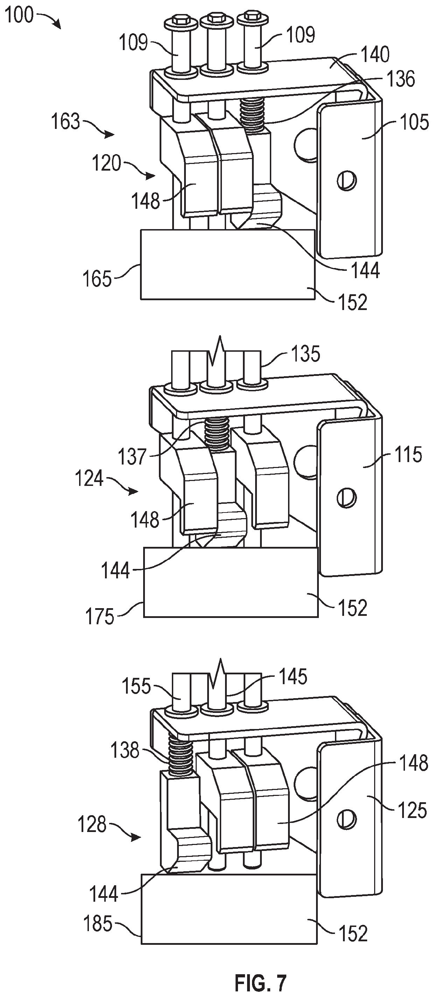

FIG. 7 shows an example of the retention system 100 in the unlocked configuration 163, with all of the CDUs (e.g., the first, second, and third CDUs 165, 175, 185) installed within the rack 116. In the unlocked configuration 163, the locking flanges 152 of the CDUs interact with the ramps 144 (e.g., the ramps on the corresponding rods) in order to compress the springs 136, 137, 138 (e.g., biasing elements 133) and move the first end 109 of the rods (e.g., the rods 135, 145, 155) past the first surface 140 of the mounting bracket (e.g., the first mounting bracket 105). Thus, the locking tabs 148 of the rods may be disengaged from the locking flanges 152 of the CDUs. As a result, when in the unlocked configuration 163, a user may be able to remove any one of the CDUs (e.g., any one of the first, second, or third CDUs 165, 175, 185).

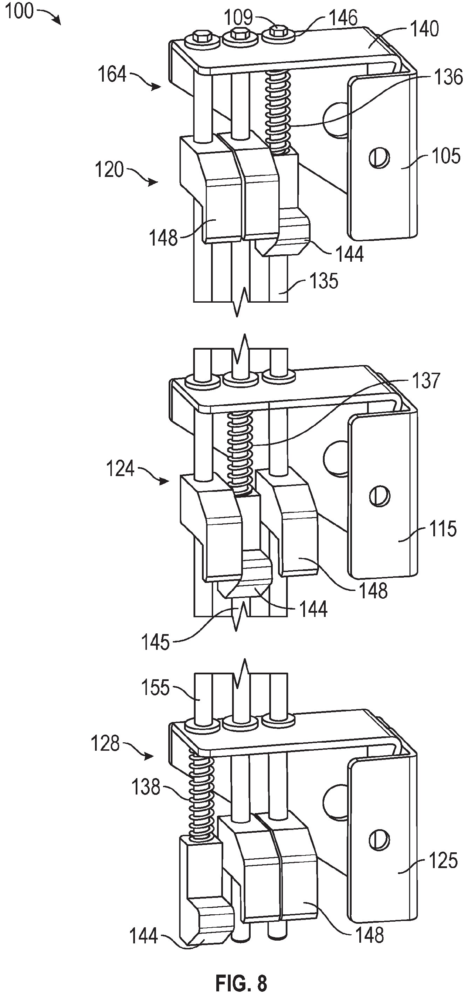

FIG. 8 shows an example of the retention system 100 in the locked configuration 164, with all of the CDUs (e.g., the first, second, and third CDUs 165, 175, 185) removed from the rack 116. In the locked configuration 164, the locking flanges 152 of the CDUs are no longer in contact with the ramps 144 (e.g., the ramps on the corresponding rods). Thus, the springs 136, 137, 138 (e.g., arranged between the corresponding ramp 144 and mounting bracket 105, 115, 125) may be decompressed, which may provide a biasing force to the move the rods 135, 145, 155 so that the first end 109 of the rods contacts the retention flange 146 of the bushing 132 coupled to the bracket 104 (e.g., the first mounting bracket 105). However, as no CDUs are installed in the rack 116, the locking tabs 148 may not be engaged with the locking flanges 152.

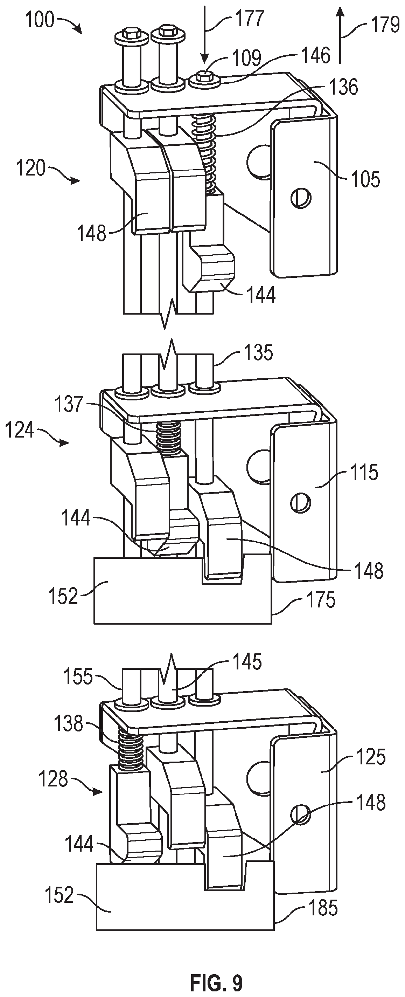

FIG. 9 shows an example of the retention system 100 in the locked configuration 164, with one of the CDUs (e.g., the first CDUs 165) removed from the rack 116. In the locked configuration 164, the locking flange 152 of the first CDU 165 is no longer in contact with the ramp 144 of the first rod 135. Thus, the spring 136 (e.g., compressed between the ramp 144 of the first rod 135 and first mounting bracket 105) may be decompressed, which may (automatically) provide a biasing force (e.g., apply a biasing force to the ramp 144 on the first rod 135) to the move the first rods 135 in the direction shown by arrow 177 until the first end 109 of the first rod 135 contacts the retention flange 146 of the bushing 132. In some examples, once the first end 109 of the first rod 135 contacts the retention flange 146 of the bushing 132, the locking tabs 148 of the first rod 135 (e.g., corresponding to the second and third CDUs 175, 185) may engage with the locking flanges 152 of the second and third CDUs 175, 185, which may lock the second and third CDUs within the rack 116 (e.g., prevent removal of the second and third CDUs).

In some examples, to return the retention system 100 to the unlocked configuration 164, the user may reinsert the first CDU 165, which may drive the locking flange 152 of the first CDU 165 into contact with ramp 144 on the first rod 135. As a result, the first rod 135 may move in the direction shown by arrow 179, which may compress the spring 136 between the ramp 144 of the first rod 135 and the first mounting bracket 105. Correspondingly, the first end 109 of the first rod 135 may protrude past first surface 140 of the first mounting bracket 105. Further, the locking tabs 148 of the first rod 135 (e.g., corresponding to the second and third CDUs 175, 185) may disengage from the locking flanges 152 of the second and third CDUs 175, 185, which may unlock the second and third CDUs from within the rack 116 (e.g., permit removal of the second and third CDUs, as well as the first CDU).

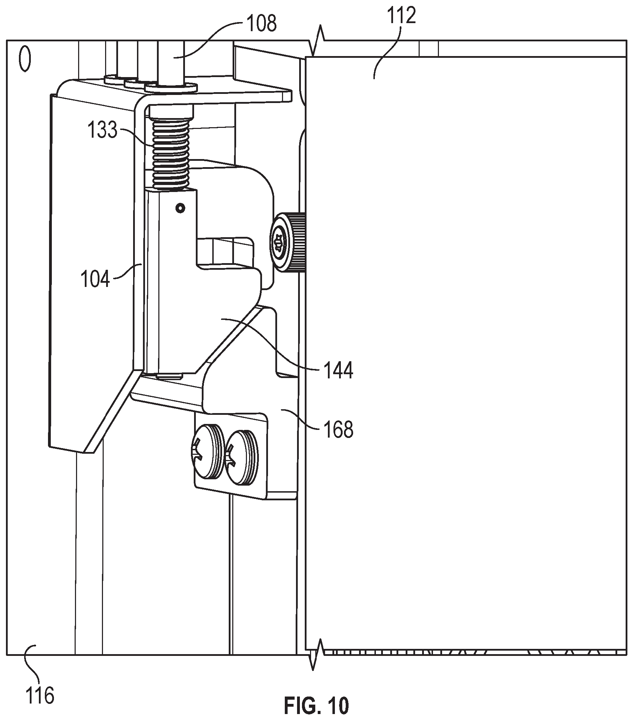

FIG. 10 illustrates another example of a locking flange 168. As will be recognized, the locking flange 168 shares a number of components in common with and operates in a similar fashion to the examples illustrated and described previously (e.g., the locking flange 152). For the sake of brevity, these common features will not be again described below in detail. Rather, previous discussions of commonly named or numbered features, unless otherwise indicated, also applies to example configurations of the locking flange 168.

In some examples, the locking flange 168 may be formed via a casting process, while the locking flange 152 may be formed via a bending process (e.g., of bending metal). Thus, the locking flange 168 may be more economical and efficient to manufacture. As should be appreciated, the locking flanges 152, 168 may be manufactured from a variety of materials (e.g., metal, metallic materials, polymeric materials, etc.) and manufactured using a variety of processes (e.g., stamping, molding, casting, additive manufacturing, etc.)

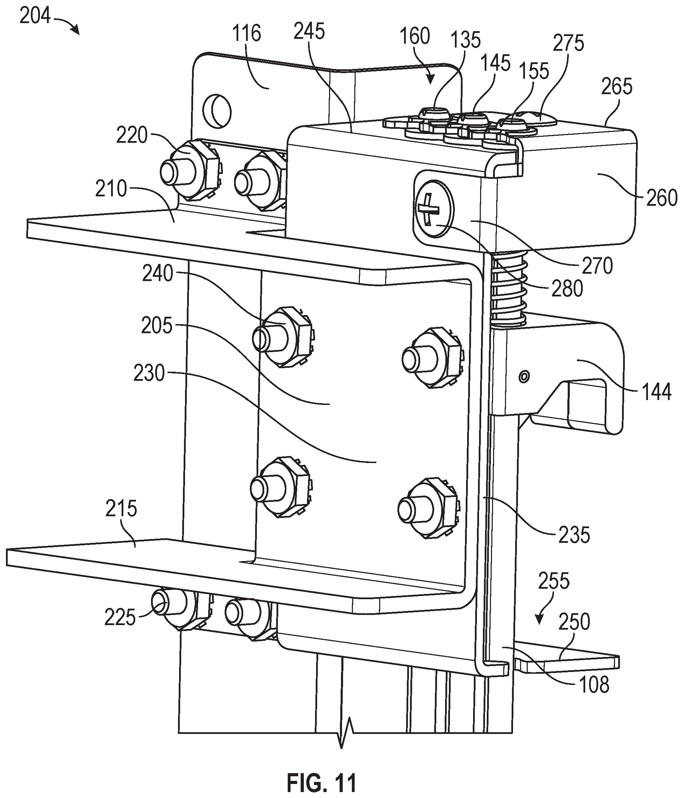

FIGS. 11-15 illustrate another example of a mounting bracket 204. As will be recognized, the mounting bracket 204 shares a number of components in common with and operates in a similar fashion to the examples illustrated and described previously in reference to the mounting bracket 104 (e.g., the mounting first mounting bracket 105, the second mounting bracket 115, the third mounting bracket 125). For the sake of brevity, these common features will not be again described below in detail. Rather, previous discussion of commonly named or numbered features, unless otherwise indicated, also applies to example configurations of the mounting bracket 204.

In some examples, the mounting bracket 204 may include a mounting plate 205 that couples the mounting bracket 204 to the rack 116. In some examples, the mounting plate 205 may include a first plate flange 210 and a second plate flange 215 that are coupled to the rack 116 via one or more first mounting plate fasteners 220 and one or more second mounting plate fasteners 225. In some examples, the mounting plate 205 may include a body 230 that extends between the first plate flange 210 and the second plate flange 215. In some examples, the body 230 may be coupled to a base 235 via one or more body fasteners 240.

In some examples, the base 235 may define a first base flange 245 and a second base flange 250. In some examples, the first base flange 245 may include the opening 160 for the rods 108 to slide through. In some examples, the second base flange 250 may include a second opening 255 for the rods 108 to slide through. In some examples, a retainer 260 of the mounting bracket 204 may couple to the base 235 to secure the rods 108 to the mounting bracket 204. In some examples, the retainer 260 may include a first retainer flange 265 and a second retainer flange 270 secured to the base 235 via one or more first retainer fasteners 275 and one or more second retainer fasteners 280 respectively. In some examples, the components of the mounting bracket 204 (e.g., the mounting plate 205, the base 235, and the retainer 260) may be integrated as a single component. For example, the mounting bracket 204 may be formed as a unitary structure through processes such as casting, molding, or additive manufacturing, rather than being assembled from separate components.

In some examples, the retainer 260 may include slots corresponding to each rod 108. For example, the retainer 260 may include a first slot 285, a second slot 290, and a third slot 295. In some examples, the slots 285, 290, 295 may receive the rods 108. In some examples, a surface of the retainer 260 defining the slots 285, 290, 295 may sit above the bushing 132 and prevent lateral movement of the rods 108. In some examples, the retainer 260 may work in conjunction with the base 235 to guide and secure the rods 108 within the bracket 104 during operation of the retention system 100. In some examples, by positioning the surface of the retainer 260 above the bushing 132, the retainer 260 may constrain the rods 108 to move vertically within the slots 285, 290, 295 while preventing the rods 108 from shifting laterally or disengaging from the bracket 104.

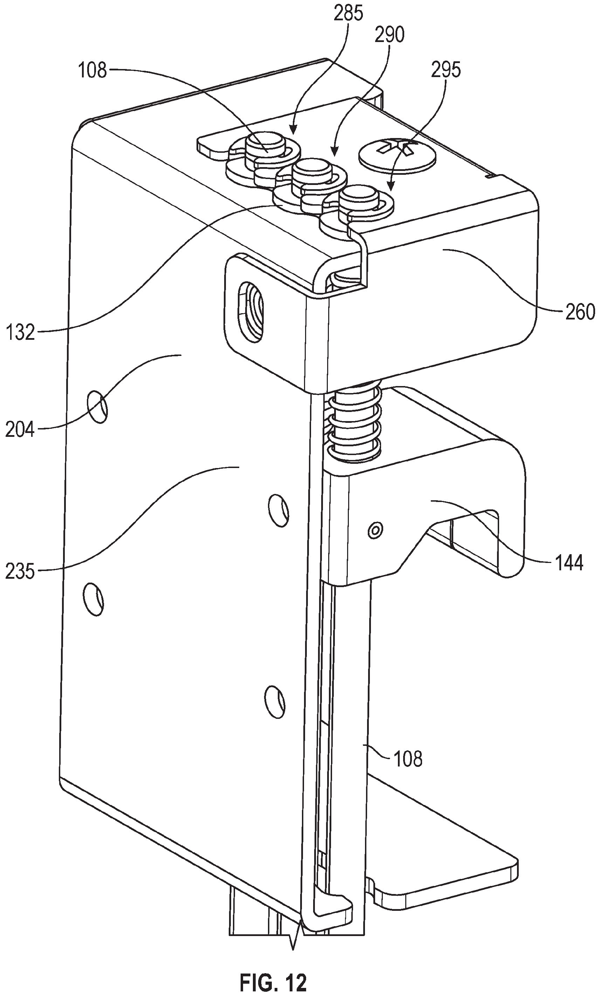

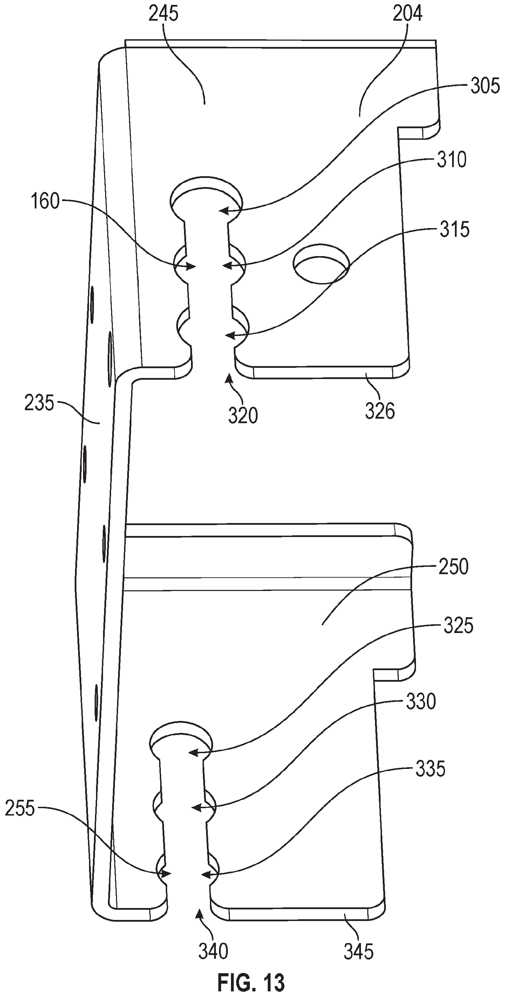

FIG. 13 illustrates the base 235 of the bracket 104. In some examples, the opening 160 of the first base flange 245 may include a first aperture 305, a second aperture 310, and a third aperture 315 that are all connected to form a continuous opening (e.g., in the form of a slot). In some examples, the first base flange 245 may include a cutout 320 at a first edge 326 of the first base flange 245 that allows the rods 108 to be slid into the opening 160 of the base 235 laterally through each aperture 305, 310, 315. Similarly, the second opening 255 of the second base flange 250 may include a fourth aperture 325, a fifth aperture 330, and a sixth aperture 335 that are all connected to form a continuous opening. In some examples, the second base flange 250 may further include a second cutout 340 at a second edge 345 of the second base flange 250 that allows the rods 108 to be slid into the base 235 laterally through each aperture 325, 330, 335. In some examples, the openings 160, 255 and cutouts 320, 340 may facilitate assembly of the retention system 100 by allowing the rods 108 to be installed laterally into the bracket 104 without requiring the rods 108 to be threaded through the openings from above or below. In some examples, once the rods 108 are installed within the openings, the retainer 260 (see, e.g., FIG. 12) may prevent lateral movement of the rods 108 within the openings, thereby securing the rods 108 within the bracket 104 while still permitting vertical movement of the rods 108 between the locked and unlocked positions.

In some examples, the retainer 260 may include a first finger 350 and a second finger 355 that, together with a body 360 of the retainer 260, form the three slots 285, 290, 295 (e.g., retaining the corresponding three rods). In some examples, the retainer 260 may include a first retention edge 365, a second retention edge 370, and a third retention edge 375 that define surfaces of the slots 285, 290, 295 and prevent lateral movement of the rods 108 relative to the slots. In some examples, the first retention edge 365 may define a surface of the first slot 285, the second retention edge 370 may define a surface of the second slot 290, and the third retention edge 375 may define a surface of the third slot 295. In some examples, the body 360 may include a first lateral surface 380, the first finger 350 may include a second lateral surface 385 and a third lateral surface 390, the second finger 355 may include a fourth lateral surface 395 and a fifth lateral surface 405, and the body 360 may include a sixth lateral surface 410, that define side surfaces of the slots 285, 290, 295 and prevent lateral movement of the rods 108 within the slots.

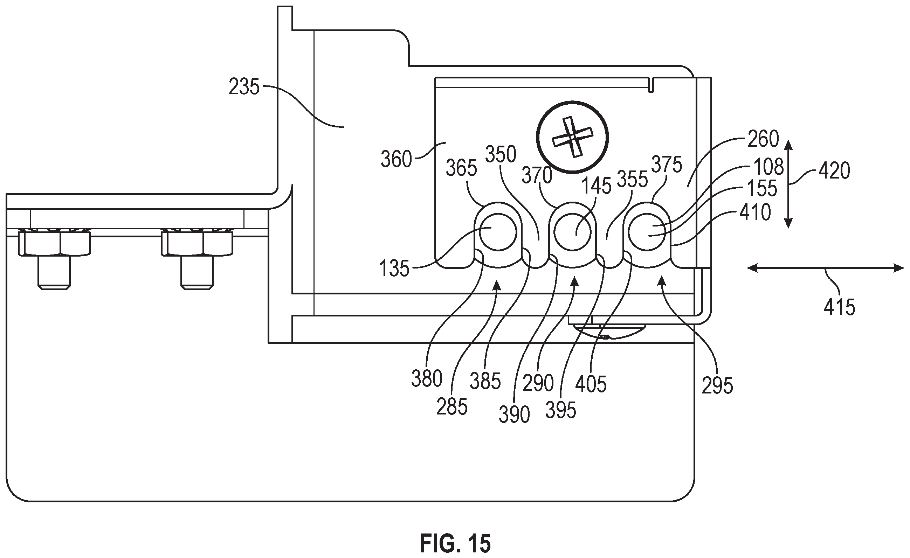

FIG. 15 illustrates a cross-sectional view of a retention assembly (e.g., the first retention assembly 120) of the retention system 100, showing the retainer 260 and the rods 108 (e.g., the first rod 135, the second rod 145, and the third rod 155) mounted within the retention assembly. In some examples, the first rod 135 may be received in the first slot 285, the second rod 145 may be received in the second slot 290, and the third rod 155 may be received in the third slot 295. In some examples, arrow 415 may indicate a direction of installation and removal of the rods 108 into the slots 285, 290, 295 (e.g., via the cutouts 320, 340).

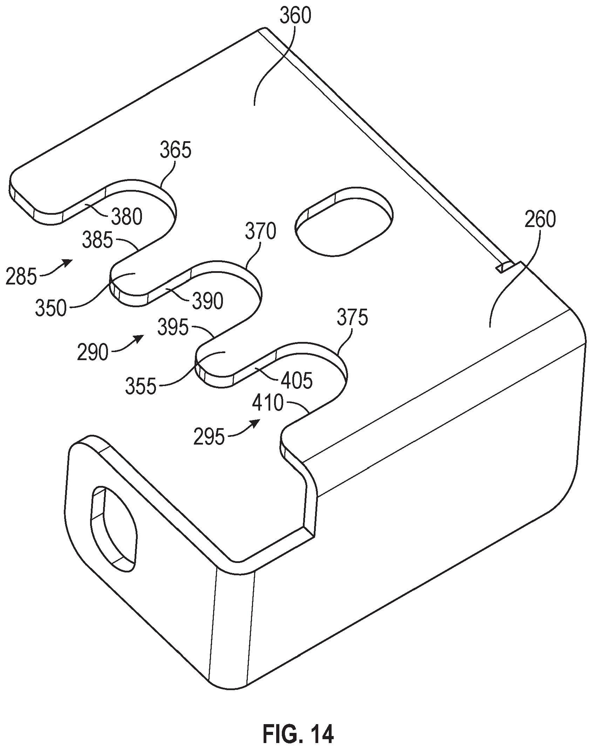

In some examples, the first lateral surface 380 (on the body 360) and second lateral surface 385 (on the first finger 350) may prevent lateral movement in the direction shown by arrows 415 of the first rod 135. In some examples, the third lateral surface 390 (on the first finger 350) and fourth lateral surface 395 (on the second finger 355) may prevent lateral movement in the direction shown by arrows 415 of the second rod 145. In some examples, the fifth lateral surface 405 (on the second finger 355) and sixth lateral surface 410 (on the body 360) may prevent lateral movement in the direction shown by arrows 415 of the third rod 155. In some examples, the retention edges 365, 370, 375 in combination with the base 235 (e.g., the first base flange 245 and the second base flange 250 as shown in FIG. 14) may prevent movement of the rods 108 in the directions indicated by arrows 420 by constraining the rods 108 between the retainer 260 and the base 235. Thus, once the rods 108 are installed within the slots 285, 290, 295, the retainer 260 may secure the rods 108 against lateral displacement while still permitting vertical movement of the rods 108 between the locked and unlocked positions

In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the invention, of the utilized features and implemented capabilities of such device or system.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. One or more features of the systems described may be incorporated into/used in a corresponding method and vice versa.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

As used herein, unless otherwise defined or limited, directional terms are used for convenience of reference for discussion of particular figures or examples. For example, references to downward (or other) directions or top (or other) positions may be used to discuss aspects of a particular example or figure, but do not necessarily require similar orientation or geometry in all installations or configurations.

Also as used herein, unless otherwise limited or defined, "substantially parallel" indicates a direction that is within ± 12 degrees of a reference direction (e.g., within ± 6 degrees), inclusive.

Also as used herein, unless otherwise limited or defined, "substantially perpendicular" indicates a direction that is within ± 12 degrees of perpendicular a reference direction (e.g., within ± 6 degrees), inclusive.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

Additionally, unless otherwise specified or limited, the terms "about" and "approximately," as used herein with respect to a reference value, refer to variations from the reference value of ± 15% or less, inclusive of the endpoints of the range. Similarly, the term "substantially equal" (and the like) as used herein with respect to a reference value refers to variations from the reference value of less than ± 10%, inclusive. Where specified, "substantially" can indicate in particular a variation in one numerical direction relative to a reference value. For example, "substantially less" than a reference value (and the like) indicates a value that is reduced from the reference value by 10% or more, and "substantially more" than a reference value (and the like) indicates a value that is increased from the reference value by 10% or more.

Also as used herein, unless otherwise limited or specified, "substantially identical" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order.

The previous description of the disclosed embodiments is provided to enable any person skilled in the art to make or use the invention. Given the benefit of this disclosure, various modifications to these embodiments will be readily apparent to those skilled in the art, and the principles defined herein may be applied to other embodiments without departing from the spirit or scope of the invention. Thus, the invention is not intended to be limited to the embodiments shown herein but is to be accorded the widest scope consistent with the principles and novel features disclosed herein.

## Claims

1. A retention system for retaining coolant distribution units (CDUs) within a rack, comprising:
a mounting bracket secured to the rack;
a first rod slidably arranged through the mounting bracket, the first rod moveable between a first unlocked position and a first locked position;
a ramp arranged on the first rod, the ramp configured to engage a first CDU to move the first rod into the first unlocked position when the first CDU is inserted into the rack, and to disengage from the first CDU to move the first rod into the first locked position when the first CDU is removed from the rack;
a locking tab arranged on the first rod, the locking tab to engage a second CDU when the first rod is in the first locked position;
the first rod configured to move from the first unlocked position to the first locked position in response to removal of the first CDU to engage the locking tab with the second CDU and lock movement of the second CDU within the rack; and
the first rod further configured to move from the first locked position to the first unlocked position in response to reinsertion of the first CDU to disengage the locking tab from the second CDU and unlock movement of the second CDU within the rack.

2. The retention system of claim 1 further comprising a biasing element arranged around the first rod, between the ramp and the mounting bracket, the biasing element biasing the first rod to the first locked position.

3. The retention system of claim 1 or claim 2, wherein the retention system permits removal of only a single CDU from the rack at a time.

4. The retention system of claim 1, claim 2 or claim 3 further comprising a locking flange secured to the first CDU, the locking flange including an angled portion to interact with the ramp and move the first rod between the first unlocked position and the first locked position.

5. The retention system of claim 4, wherein the angled portion of the locking flange contacts a corresponding angled portion of the ramp to move the first rod from the first unlocked position to the first locked position; and/or
wherein the locking flange defines a gap between the locking flange and the first CDU, and wherein the locking tab is arranged within the gap when the first rod is in the first locked position.

6. The retention system of claim 1 or of any preceding claim, further comprising a second rod arranged through the mounting bracket, the second rod including a second ramp at a location corresponding to the second CDU and a second locking tab at a location corresponding to the first CDU; and, optionally,
wherein removal of the second CDU from the rack moves the second rod into a second locked position to engage the second locking tab with a second locking flange of the first CDU; and, optionally,
wherein the first rod and the second rod are each independently moveable such that removal of the first CDU only moves the first rod and removal of the second CDU only moves the second rod.

7. A retention system for retaining coolant distribution units (CDUs) within a rack, comprising:
a mounting bracket secured to the rack;
a first rod slidably arranged through the mounting bracket, the first rod moveable between a first unlocked position and a first locked position, the first rod including:
a first ramp configured to engage a first CDU, and
a first locking tab configured to engage a second CDU;
a second rod slidably arranged through the mounting bracket, the second rod moveable between a second unlocked position and a second locked position, the second rod including:
a second ramp configured to engage the second CDU, and
a second locking tab configured to engage the first CDU;
the first rod configured to move from the first unlocked position to the first locked position in response to removal of the first CDU to engage the first locking tab with the second CDU and lock movement of the second CDU within the rack; and
the second rod configured to move from the second unlocked position to the second locked position in response to removal of the second CDU to engage the second locking tab with the first CDU and lock movement of the first CDU within the rack.

8. The retention system of claim 7 further comprising a first biasing element arranged around the first rod and a second biasing element arranged around the second rod.

9. The retention system of claim 8, wherein the first biasing element automatically moves the first rod into the first locked position when the first CDU is removed from the rack, and wherein the second biasing element automatically moves the second rod into the second locked position when the second CDU is removed from the rack.

10. The retention system of claim 7, claim 8 or claim 9, further comprising a first locking flange secured to the first CDU and a second locking flange secured to the second CDU, the first locking flange including a first angled portion to interact with the first ramp and the second locking flange including a second angled portion to interact with the second ramp; and, optionally,
wherein the first locking flange defines a first gap between the first locking flange and the first CDU, and wherein the second locking tab is arranged within the first gap when the second rod is in the second locked position.

11. The retention system of claim 7 or of any of claims 8 to 10, wherein the first rod and the second rod are each independently moveable such that removal of the first CDU moves only the first rod into the first locked position and removal of the second CDU moves only the second rod into the second locked position.

12. A method of securing coolant distribution units (CDUs) within a rack, the method comprising:
removing a first CDU from the rack;
disengaging the first CDU from a ramp arranged on a rod that is slidably arranged through a mounting bracket secured to the rack;
automatically moving the rod from an unlocked position to a locked position via a biasing element in response to removal of the first CDU;
engaging a locking tab arranged on the rod with a corresponding locking flange of a second CDU within the rack as the rod moves into the locked position; and
preventing removal of the second CDU from the rack while the locking tab is engaged with the locking flange.

13. The method of claim 12, further comprising:
reinserting the first CDU into the rack;
automatically moving the rod into an unlocked position in response to reinsertion of the first CDU;
disengaging the locking tab from the locking flange of the second CDU; and
permitting removal of the first CDU or the second CDU from the rack when the locking tab is disengaged from the locking flange.

14. The method of claim 13, wherein automatically moving the rod into the unlocked position includes compressing the biasing element via contact between the first CDU and the ramp.

15. The method of claim 12, claim 13 or claim 14, wherein automatically moving the rod into the locked position includes decompressing the biasing element to move the rod along a longitudinal axis of the rod until the locking tab engages the locking flange of the second CDU; and/or
further comprising manually lifting the rod to disengage the locking tab from the locking flange to permit removal of multiple CDUs from the rack.
